# EUROPEAN PATENT APPLICATION

(11) **EP 4 835 612 A1**
(43) Date of publication of application: **04.11.2026**
(21) Application number: 24931321.4
(22) Date of filing: 25.03.2024
(51) Int. Cl.: G06F 1/26, H05K 1/11

(54) **VERTICAL POWER SUPPLY SYSTEM**

(71) Applicant: New H3C Technologies Co., Ltd., Hangzhou, Zhejiang 310052 (CN)
(72) Inventor: ZHANG, Yujun, Beijing 100102 (CN); LU, Yan, Beijing 100102 (CN); ZHU, Shiyin, Beijing 100102 (CN); LIU, Feng, Beijing 100102 (CN)
(74) Representative: 2SPL Patentanwälte PartG mbB
(86) International application number: PCT/CN2024/083663
(87) International publication number: WO 2025/199708

(57) **Abstract**

The present disclosure provides a vertical power supply system, including: a processor, a mainboard and a vertical power supply circuit, where the vertical power supply circuit includes a PB carrier plate and a PB module; the processor is connected to a first surface of the mainboard through first fixtures, the PB carrier plate is connected to a second surface of the mainboard through second fixtures, for each of the second fixtures, the second fixture corresponds to one of the first fixtures, and the second fixture is connected to the corresponding first fixture by a through hole in the mainboard; the PB module is connected to the PB carrier plate through third fixtures, the PB module is configured to convert an input power supply to a target power supply; the target power supply is configured to supply power to the processor through the third fixtures, the PB carrier plate, the second fixtures, the through holes in the mainboard and the first fixtures. According to the technical solution of the present disclosure, power supply transmission loss can be reduced, and heat dissipation of the power supply system is good.

## Description

### TECHNICAL FIELD

The present disclosure relates to the technical field of circuit design, and in particular, to a vertical power supply system.

### BACKGROUND

With growth of application requirements of artificial intelligence and big data, higher requirements are put on performance of a processor, and a working current of the processor is continuously increased, for example, the working current reaches 1000A and above.

When the processor is powered by a power supply, the power supply and the processor are located on a same plane, so that there is a long distance between the power supply and the processor, for example, the distance may be 2-3cm, which results in a relatively large power supply transmission loss, and the relatively large power supply transmission loss is released in a form of heat, which further results in poor heat dissipation of a power supply system.

For example, the power supply transmission loss is calculated in a following manner: I*I*DCR, where DCR (Direct Current Resistance) is related to a power transmission distance, and the larger the power transmission distance is, the larger the DCR is.

Obviously, when a working current is large (e.g., 1000A) and a distance between the power supply and the processor is long (e.g., the distance is 2-3cm), in such case, a power supply transmission loss is large, and heat dissipation of the power supply system is poor.

### SUMMARY

The present disclosure provides a vertical power supply system, including: a processor, a mainboard and a vertical power supply circuit, where the vertical power supply circuit includes a power block (PB) carrier plate and a PB module;
the processor is connected to a first surface of the mainboard through first fixtures, the PB carrier plate is connected to a second surface of the mainboard through second fixtures; where the first surface is a front surface and the second surface is a back surface, or the first surface is a back surface and the second surface is a front surface;
for each of the second fixtures, the second fixture corresponds to one of the first fixtures, and the second fixture is connected to the corresponding first fixture by a through hole in the mainboard;
the PB module is connected to the PB carrier plate through third fixtures, where the PB module is configured to convert an input power supply to a target power supply; and
the target power supply is configured to supply power to the processor through the third fixtures, the PB carrier plate, the second fixtures, the through holes in the mainboard and the first fixtures.

In an embodiment, the vertical power supply circuit further includes an input capacitor and an output capacitor corresponding to the PB module, the PB module is connected to the input capacitor, and the PB module is connected to the output capacitor;
the input power supply enters the PB module through the input capacitor.

In an embodiment, after the PB module converts the input power supply to the target power supply, the target power supply enters the PB carrier plate through the output capacitor and the third fixtures.

In an embodiment, the number of PB modules is multiple, and each of the PB modules corresponds to a plurality of input capacitors and a plurality of output capacitors, and a number of the output capacitors is more than a number of the input capacitors.

In an embodiment, the PB module is configured to convert the input power supply of a first voltage to the target power supply of a second voltage; where the first voltage is a voltage supported by an external power supply, the second voltage is a voltage supported by the processor, and the first voltage is greater than the second voltage.

For one of the second fixtures and one of the first fixtures corresponding to each other, a power supply type supported by the second fixture is same as a power supply type supported by the first fixture; and the power supply type is a positive power supply electrode or a negative power supply electrode.

In an embodiment, when the PB module is connected to the PB carrier plate through the third fixtures, the PB module and the third fixtures are placed on a front surface of the PB carrier plate;
when the PB carrier plate is connected to the second surface of the mainboard through the second fixtures, the second fixtures are placed on a back surface of the PB carrier plate.

In an embodiment, the first fixtures include ball grid array (BGA) solder balls; the second fixtures include BGA solder balls; and the third fixtures include BGA solder balls.

In an embodiment, the processor is a high-performance processor applied in artificial intelligence or big data;
the high-performance processor includes a high-performance central processing unit (CPU), a high-performance graphics processing unit (GPU), and a high-performance data processing unit (DPU).

In an embodiment, the PB carrier plate is a PB carrier plate optimized in a target optimization manner;
the target optimization manner includes at least one of:
a copper plating optimization manner, a lamination optimization manner, a through hole optimization manner and a blind hole optimization manner.

The through holes in the mainboard are conductive through holes, and the through holes include copper-plated through holes.

As can be seen from the above technical solution, a vertical power supply system is proposed so that the processor and the PB carrier plate are designed to be arranged back-to-back, that is, the processor is connected to the first surface of the mainboard through the first fixtures, the PB carrier plate is connected to the second surface of the mainboard through the second fixtures, thereby significantly reducing a distance between the processor and the PB carrier plate. Since the distance between the processor and the PB carrier plate is small, when the PB module is supplying power to the processor through the PB carrier plate, power supply transmission loss can be reduced, and heat dissipation of the power supply system is good.

For example, when a working current is large (e.g., 1000A), even though there is only a small change in the distance between the PB carrier plate and the processor, the power supply transmission loss can still be restricted and reduced. For example, when the distance is reduced from 2-3cm to 2-3mm, the distance is reduced by an order of magnitude, the power supply transmission loss is restricted and reduced.

By implementing power supply by using the PB module, power supply cost can be reduced, and power usage efficiency can be improved.

### BRIEF DESCRIPTION OF DRAWINGS

To describe technical solutions in the embodiments of the present disclosure or the prior art more clearly, accompanying drawings that need to be used in the embodiments of the present disclosure or the prior art description are briefly described in the following, and obviously, the accompanying drawings in the following description are merely some embodiments described in the present disclosure, and for a person of ordinary skill in the art, other accompanying drawings may be obtained based on these accompanying drawings in the embodiments of the present disclosure.
FIG. 1 is a schematic diagram of a horizontal power supply manner according to the present disclosure.
FIG. 2 is a schematic diagram of a vertical power supply manner according to the present disclosure.
FIG. 3 is a schematic structural diagram of a vertical power supply system according to the present disclosure.
FIG. 4 is a schematic structural diagram of a vertical power supply circuit according to the present disclosure.

### DETAILED DESCRIPTION

The terminology used in the embodiments of the present disclosure is merely for the purpose of describing a specific embodiment, and is not intended to limit the present disclosure. As used in the present disclosure and the claims, singular forms "a", "the", and "said" are also intended to include plural forms unless the context clearly indicates other meanings. It should also be understood that the term "and/or" as used herein refers to any or all possible combinations containing one or more associated listed items.

It should be understood that although the terms "first", "second", "third", etc., may be used to describe various information in the embodiments of the present disclosure, these information should not be limited to these terms. These terms are only used to distinguish a same type of information from each other. For example, without departing from the scope of the present disclosure, first information may also be referred to as second information, and similarly, the second information may also be referred to as the first information. Depending on the context, moreover, the word "if" used may be interpreted as "when" or "upon" or "in response to determining".

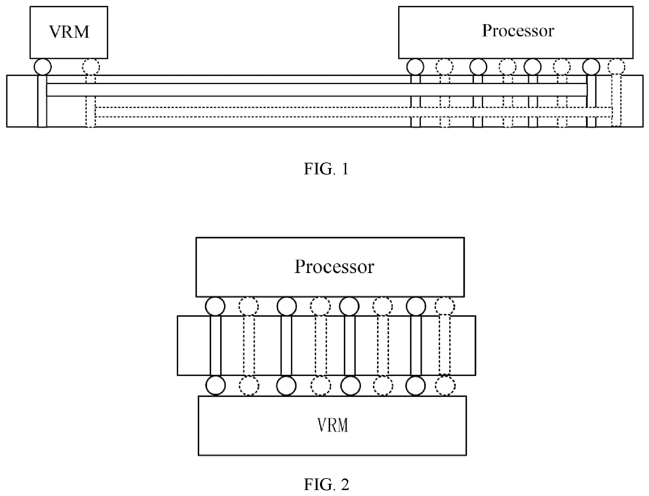

When a power supply supplies power to a processor, a horizontal power supply manner is usually used, and the horizontal power supply manner means that the power supply and the processor are located on a same plane. FIG. 1 is a schematic diagram of a horizontal power supply manner. A voltage regulator module (VRM) may be the power supply, and the processor may be a power receiver, and obviously, the VRM and the processor are at a same plane.

In FIG. 1, solid lines indicate power positive connection lines between the VRM and the processor, and dotted lines indicate power negative connection lines between the VRM and the processor, and the power negative connection lines may be represented by ground (GND). The power positive connection lines and the power negative connection lines may be deployed on a mainboard, that is, implemented by wiring the mainboard.

Referring to FIG. 1, when the power supply and the processor are located on a same plane, a distance between the power supply and the processor is relatively long, for example, the distance is 2 -3cm. Therefore, a power supply transmission loss is relatively large, and a relatively large power supply transmission loss is released in a form of heat, and heat dissipation of the power supply system is relatively poor.

For example, the power supply transmission loss is calculated in a following manner: I*I*DCR. DCR refers to a resistance of an electronic component or circuit under a direct current (DC) condition. DCR affects efficiency of current flow and power loss. The DCR is related to a power supply transmission distance, and the larger the power supply transmission distance is, the larger the DCR is.

With growth of application requirements such as artificial intelligence and big data, higher requirements are placed on performance of processors. A working current of the processor continuously increases, for example, the working current reaches 1000A or above, for example, I is 1000A. Obviously, when the working current is large (for example, 1000A), and when the distance between the power supply and the processor is large (for example, the distance is 2-3cm), the power supply transmission loss is large, and the heat dissipation of the power supply system is poor.

For the foregoing discovery, the present disclosure provides a vertical power supply system, and based on the vertical power supply system, a vertical power supply manner may be used when a power supply supplies power to a processor. For example, the vertical power supply manner refers to that the power supply and the processor are placed back-to-back on two sides (such as a front side and a back side) of a mainboard.

Referring to FIG. 2, FIG. 2 is a schematic diagram of a vertical power supply manner, the VRM may be a power supply, and the processor may be a power receiver. Obviously, the VRM and the processor are placed back-to-back on two sides of the mainboard.

In FIG. 2, solid lines indicate power positive connection lines between the VRM and the processor, and dotted lines indicate power negative connection lines between the VRM and the processor, and the power negative connection lines may be represented by ground (GND). The power positive connection lines and the power negative connection lines may be deployed on a mainboard, that is, implemented by wiring the mainboard.

Referring to FIG. 2, when the power supply and the processor are placed back-to-back on two sides of the mainboard, a distance between the power supply and the processor is close, for example, the distance is 2-3mm. Obviously, compared with the distance of the horizontal power supply manner, the distance of the vertical power supply manner is reduced by an order of magnitude, and the DCR is also reduced by an order of magnitude.

Compared with the horizontal power supply manner, the vertical power supply manner can significantly reduce the power supply transmission loss, and when the smaller power supply transmission loss is released in the form of heat, the heat dissipation of the power supply system is better.

For example, the power supply transmission loss is calculated in the following manner: I*I*DCR, where DCR is related to the power supply transmission distance, and DCR is less when the power supply transmission distance is shorter. Obviously, when the working current is large (for example, 1000A), and when the distance between the power supply and the processor is close, the power supply transmission loss can be significantly reduced.

The present disclosure provides a vertical power supply system, where the vertical power supply system may include: a processor, a mainboard and a vertical power supply circuit. The vertical power supply circuit may be a power supply, and the vertical power supply circuit may include a PB (Power Block) carrier plate and a PB module (i.e., a small package power module).

In an example, the vertical power circuit may supply power only to the processor, but not supply power to components (for example, a memory or a hard disk) other than the processor, that is the vertical power supply circuit is a power supply for the processor.

In an example, the processor may be a high-performance processor, for example, a high-performance processor applied in artificial intelligence or big data. Certainly, the processor may also be a high-performance processor adopted in other scenarios.

For example, in artificial intelligence or big data, a high-performance processor needs to be used to implement processing functions such as computing. Based on this, a power supply may be independently provided for the high-performance processor, that is, the power supply independently supplies power to the high-performance processor, instead of simultaneously supplying power to a plurality of components.

For example, the high-performance processor may include, but is not limited to, a high-performance CPU (Central Processing Unit), a high-performance GPU (Graphics Processing Unit), and a high-performance DPU (Data Processing Unit), where the CPU, GPU and DPU may be collectively referred to as an xPU. Certainly, the CPU, GPU and DPU are merely examples, which are not limited.

In an example, the mainboard may also be referred to as a motherboard, where the motherboard is a circuit board for carrying the processor and the vertical power circuit, and a structure and design of the mainboard are not limited.

In an example, the vertical power supply circuit may be a power supply, and the vertical power supply circuit may supply power to the processor in a vertical power supply manner, that is, the vertical power supply circuit and the processor are placed back-to-back on two sides of the mainboard. For example, the vertical power supply circuit is placed on a front side of the mainboard, and the processor is placed on a back side of the mainboard, or the vertical power supply circuit is placed on a back side of the mainboard, and the processor is placed on a front side of the mainboard.

The vertical power supply circuit may include a PB carrier plate and a PB module, and the PB module may be placed on the PB carrier plate. The PB carrier plate is a circuit plate for carrying the PB module, and the PB module is a small package power module, which is a module for providing power, that is, the PB module is used to construct a power supply for processor.

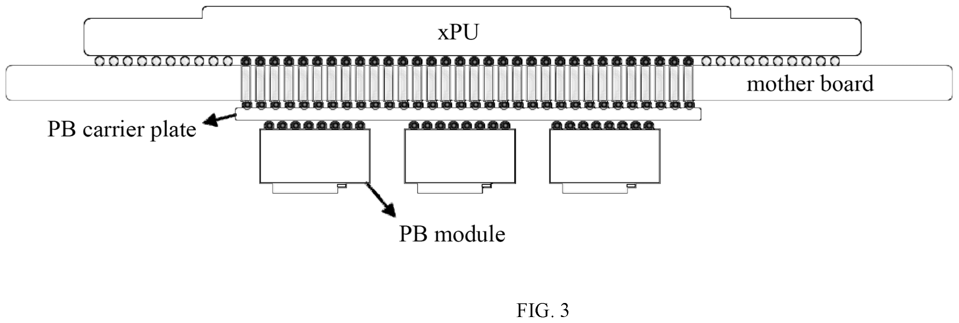

Referring to FIG. 3, FIG. 3 is a schematic structural diagram of a vertical power supply system, the vertical power supply system may include an xPU, a motherboard, a PB carrier plate and a PB module. The xPU may be a CPU, a GPU, a DPU, or the like, and the xPU is used as a processor. The motherboard may serve as a mainboard. The PB carrier plate and the PB module may be used as a vertical power supply circuit, that is, the vertical power supply circuit includes the PB carrier plate and the PB module.

Referring to FIG. 3, the processor is connected to a first surface of the mainboard through a plurality of first fixtures, and the PB carrier plate is connected to a second surface of the mainboard through a plurality of second fixtures. The first surface may be a front surface and the second surface may be a back surface, or the first surface may be a back surface and the second surface may be a front surface. For example, FIG. 3 illustrates that the processor is connected to the front surface of the mainboard through a plurality of first fixtures, and the PB carrier plate is connected to the back surface of the mainboard through a plurality of second fixtures.

In an example, the first fixture may include, but is not limited to, a ball grid array (BGA) solder ball. Certainly, the first fixture may also be other types of solder balls, or the first fixture may also be other types of fixtures, as long as the processor can be fixedly connected to the mainboard. In addition to a fixedly-connecting function, the first fixture further has a conductive function, that is, electricity can be conducted from the mainboard to the processor.

The second fixture may include, but is not limited to, BGA solder balls. The second fixture may also be other types of solder balls, or the second fixture may also be other types of fixtures, as long as the PB carrier plate can be fixedly connected to the mainboard. The second fixture further has a conductive function, that is, electricity can be conducted from the PB carrier plate to the mainboard.

In an example, a number of the first fixtures may be greater than or equal to a number of the second fixtures, and in FIG. 3, an example in which the number of the first fixtures is greater than the number of the second fixtures is used for description.

A plurality of second fixtures are in one-to-one correspondence with a plurality of first fixtures. For each second fixture, the second fixture corresponds to one first fixture, and the second fixture corresponds to at most one first fixture. For each first fixture, the first fixture may correspond to one second fixture, and the first fixture may correspond to at most one second fixture, or the first fixture may not correspond to any second fixture.

For example, assuming that the plurality of second fixtures include second fixtures b1-b3, and the plurality of first fixtures include first fixtures a1-a7, then, the second fixture b1 corresponds to the first fixture a3, the second fixture b2 corresponds to the first fixture a4, and the second fixture b3 corresponds to the first fixture a5. However, the first fixture a1, the first fixture a2, the first fixture a6, and the first fixture a7 do not correspond to any second fixture.

In an example, when the plurality of second fixtures are in one-to-one correspondence with the plurality of first fixtures, for each second fixture, the second fixture is connected to a first fixture corresponding to the second fixture through a through hole in the mainboard, that is, the second fixture is connected with the first fixture through the through hole. For example, the second fixture b1 and the first fixture a3 are connected through a through hole c1 in the mainboard, the second fixture b2 and the first fixture a4 are connected through a through hole c2 in the mainboard, and the second fixture b3 and the first fixture a5 are connected through a through hole c3 in the mainboard.

For example, the through hole in the mainboard may be a conductive through hole, and the through hole may include but is not limited to a copper plated through hole, that is, the copper plated through hole supports a conductive function. Certainly, the through hole may also be other types of through holes, as long as the through hole supports the conductive function. For example, the through hole c1 between the second fixture b1 and the first fixture a3 is a copper-plated through hole, the through hole c2 between the second fixture b2 and the first fixture a4 is a copper-plated through hole, and the through hole c3 between the second fixture b2 and the first fixture a3 is a copper-plated through hole.

For example, when a second fixture corresponds to a first fixture, a power supply type supported by the second fixture is same as a power supply type supported by the first fixture, where the power supply type may be a positive power supply electrode or a negative power supply electrode (for example, the negative power supply electrode is represented by ground (GND)). For example, the power supply type supported by the second fixture b1 is same as the power supply type supported by the first fixture a3, for example, the second fixture b1 supports the positive power supply electrode, and the first fixture a3 supports the positive power supply electrode. The power supply type supported by the second fixture b2 is same as the power supply type supported by the first fixture a4, for example, the second fixture b2 supports the negative power supply electrode, and the first fixture a4 supports the negative power supply electrode. The power supply type supported by the second fixture b3 is same as the power supply type supported by the first fixture a5, for example, the second fixture b3 supports the negative power supply electrode, and the first fixture a5 supports the negative power supply electrode.

In an example, the power supply type supported by the second fixture refers to a pin definition of the PB carrier plate, that is, when a pin of the PB carrier plate contacts the second fixture, the pin definition of the pin is used as the power supply type supported by the second fixture. For example, when a certain pin of the PB carrier plate is in contact with the second fixture b1, if a pin definition of the pin is a positive power supply electrode, the power supply type of the second fixture b1 is the positive power supply electrode.

The power supply type supported by the first fixture refers to a pin definition of the processor (for example, a processor chip), that is, when a pin of the processor contacts the first fixture, the pin definition of the pin is used as the power supply type of the first fixture. For example, when a certain pin of the processor is in contact with the first fixture a3, if a pin definition of the pin is a positive power supply electrode, the power supply type of the first fixture a3 is the positive power supply electrode.

In conclusion, the power supply type supported by the second fixture being same as the power supply type supported by the first fixture refers to that a pin definition corresponding to the second fixture is same as a pin definition corresponding to the first fixture, and the PB carrier plate can convert an output of the PB module into output pins that are in one-to-one correspondence with input pins of the processor.

Still referring to FIG. 3, the PB module may be connected to the PB carrier plate through a plurality of third fixtures, and the PB carrier plate may be connected to the mainboard through the plurality of second fixtures. For example, when the PB module is connected to the PB carrier plate through the plurality of third fixtures, the PB module and the plurality of third fixtures are placed on the front surface of the PB carrier plate, that is, the PB module is connected to the front surface of the PB carrier plate through the plurality of third fixtures. When the PB carrier plate is connected to the mainboard through the plurality of second fixtures, the plurality of second fixtures are placed on the back surface of the PB carrier plate, that is, the back surface of the PB carrier plate is connected to the mainboard through the plurality of second fixtures.

Alternatively, when the PB module is connected to the PB carrier plate through the plurality of third fixtures, the PB module and the plurality of third fixtures are placed on the back surface of the PB carrier plate, that is, the PB module is connected to the back surface of the PB carrier plate through the plurality of third fixtures. When the PB carrier plate is connected to the mainboard through the plurality of second fixtures, the plurality of second fixtures are placed on the front surface of the PB carrier plate, that is, the front surface of the PB carrier plate is connected to the mainboard through the plurality of second fixtures.

FIG. 3 is an example in which the PB module and the plurality of third fixtures are placed on the front surface of the PB carrier plate.

In an example, the third fixtures may include, but are not limited to, BGA solder balls. The third fixtures may also be other types of solder balls or other types of fixtures, as long as the PB module can be fixedly connected to the PB carrier plate. The third fixture further has a conductive function, that is, electricity can be conducted from the PB module to the PB carrier plate.

In an example, a number of the third fixtures may be greater than a number of the second fixtures, the number of the third fixtures may be equal to the number of the second fixtures, the number of the third fixtures may be less than the number of the second fixtures, and the number of the third fixtures is not limited, and may be set according to practical applications.

In an example, the PB carrier plate may be a PB carrier plate optimized in a target optimization manner, that is, the PB carrier plate is optimized in the target optimization manner, which is not limited. By optimizing the PB carrier plate by the target optimization manner, the DCR (direct current resistance) can be reduced.

For example, the target optimization manner may include but is not limited to at least one of the following: a copper plating optimization manner, a lamination optimization manner, a through hole optimization manner and a blind hole optimization manner. The copper plating optimization manner refers to: in a design process of the PB carrier plate, copper plating optimization is performed on wiring of the PB carrier plate, such as copper plating size optimization, copper plating thickness optimization, copper plating area optimization and the like, and the DCR (direct current resistance) is reduced through these optimization manners.

The lamination optimization manner refers to: in a design process of the PB carrier plate, a lamination of the PB carrier plate is optimized, for example, the PB carrier plate includes a plurality of laminated layers, and the plurality of laminated layers are optimized to reduce the DCR.

The through hole optimization manner refers to: the through hole of the PB carrier plate is optimized in a design process of the PB carrier plate, and the through hole of the PB carrier plate is optimized to reduce the DCR.

The blind hole optimization manner refers to: the blind hole of the PB carrier plate is optimized in a design process of the PB carrier plate, and the blind hole of the PB carrier plate is optimized to reduce the DCR.

Still referring to FIG. 3, the PB module converts an input power supply into a target power supply, and after the target power supply is obtained, the target power supply supplies power to the processor through the PB module, the plurality of third fixtures, the PB carrier plate, the plurality of second fixtures, the through hole in the mainboard, and the plurality of first fixtures.

For example, the target power supply may be provided to the processor through the plurality of third fixtures, the PB carrier plate, the plurality of second fixtures, the through holes in the mainboard, and the plurality of first fixtures, so as to supply power to the processor through the target power supply, that is, power is supplied only to the processor through the target power supply instead of any other components.

For example, the PB carrier plate provides the target power supply to the plurality of second fixtures, the plurality of second fixtures provide the target power supply to the through holes in the mainboard, the through holes in the mainboard provide the target power supply to the plurality of first fixtures, and the plurality of first fixtures provide the target power supply to the processor, that is, power is supplied to the processor through the target power supply.

In an example, the PB module may acquire an input power supply. For example, an external power supply may provide the input power supply to the PB module through the mainboard, the plurality of second fixtures, the PB carrier plate and the plurality of third fixtures.

The PB module is soldered on the PB carrier plate, and the PB module is a small-package power module and is a module for providing power supply. After acquiring the input power supply, the PB module may convert the input power supply into the target power supply. For example, the PB module may convert the input power supply of a first voltage into the target power supply of a second voltage.

For example, the first voltage is a voltage supported by the external power supply, and therefore, the voltage of the input power supply is the first voltage. The second voltage is a voltage supported by the processor, and therefore, the voltage of the target power supply is the second voltage.

The first voltage may be greater than the second voltage. For example, the first voltage may be a 12V voltage, the second voltage may be a 1V voltage or a 0.75V voltage, and the first voltage and the second voltage are not limited.

After acquiring the input power supply of the first voltage, the PB module may convert the input power supply of the first voltage into the target power supply of the second voltage, where the conversion manner is not limited, and the PB module may provide the target power supply of the second voltage to the PB carrier plate through the plurality of third fixtures. The PB carrier plate provides the target power supply of the second voltage to the processor through the plurality of second fixtures, the through holes in the mainboard and the plurality of first fixtures.

In an example, since the PB carrier plate and the processor are back-to-back and a power supply transmission distance is small, after obtaining the target power supply, the PB carrier board may directly supply power to the processor through the through holes in the mainboard, that is, the target power supply reaches the processor through the plurality of second fixtures, the through holes in the mainboard, and the plurality of first fixtures.

The PB carrier plate collects outputs of a plurality of PB modules. For example, the PB carrier plate may acquire target power supplies of the plurality of PB modules, and collect the target power supplies of the plurality of PB modules to obtain a collected target power supply. The PB carrier plate provides the collected target power supply to the processor through the through holes in the mainboard.

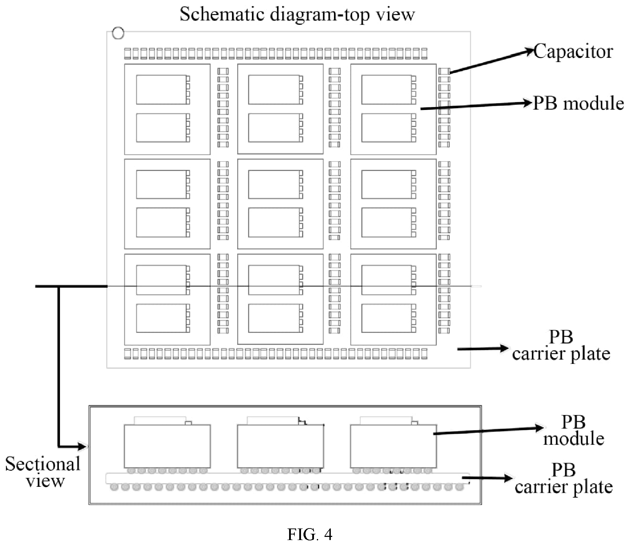

Referring to FIG. 4, FIG. 4 is a schematic structural diagram of a vertical power supply circuit, and FIG. 4 is a top view of the vertical power supply circuit. In addition to the PB carrier plate and the PB module, the vertical power supply circuit may further include a capacitor corresponding to the PB module. The capacitor may be categorized as an input capacitor and an output capacitor, therefore, the vertical power supply circuit may further include an input capacitor and an output capacitor corresponding to the PB module. The PB module is connected to the input capacitor (the connection relationship is not shown in FIG. 4), and the PB module is connected to the output capacitor (the connection relationship is not shown in FIG. 4).

Referring to FIG. 4, when the PB module is deployed on the PB carrier plate, there may be a plurality of PB modules, and a number of the PB modules may be set according to a requirement of the processor, a size of the PB carrier plate, and a size of the PB module.

For example, in order to meet the power supply requirement of the processor, 9 PB modules are required to simultaneously supply power to the processor, and 9 PB modules can be deployed on the PB carrier plate based on the size of the PB carrier plate and the size of the PB module, and then 9 PB modules or more PB modules can be deployed on the PB carrier plate.

Referring to FIG. 4, for each PB module, the PB module may correspond to a plurality of input capacitors and a plurality of output capacitors, and a number of the input capacitors and a number of the output capacitors are not limited and may be set arbitrarily.

For example, in order to meet a requirement of the processor, there are many output capacitors, and by designing a plurality of output capacitors, the processor can obtain a larger power supply, thereby meeting a high-performance computing requirement.

For example, the number of output capacitors may be greater than the number of input capacitors, and certainly, the number of output capacitors may also be less than the number of input capacitors, and the number of output capacitors may also be equal to the number of input capacitors.

In an example, for each PB module, when the PB module obtains the input power supply, the input power supply passes through the input capacitors (that is, the plurality of input capacitors corresponding to the PB module) and enters the PB module.

In an example, for each PB module, after the PB module converts the input power supply into the target power supply, the target power supply passes through the output capacitors (that is, the plurality of output capacitors corresponding to the PB module) and the plurality of third fixtures, and enters the PB carrier plate, that is, the target power supply sequentially passes through the output capacitors and the plurality of third fixtures to enter the PB carrier plate.

As can be seen from the above technical solution, a vertical power supply system is proposed so that the processor and the PB carrier plate are designed to be arranged back-to-back, that is, the processor is connected to the first surface of the mainboard through the first fixtures, the PB carrier plate is connected to the second surface of the mainboard through the second fixtures, thereby significantly reducing a distance between the processor and the PB carrier plate. Since the distance between the processor and the PB carrier plate is small, when the PB module is supplying power to the processor through the PB carrier plate, power supply transmission loss can be reduced, and heat dissipation of the power supply system is good.

For example, when a working current is large (e.g., 1000A), even though there is only a small change in the distance between the PB carrier plate and the processor, the power supply transmission loss can still be restricted and reduced. For example, when the distance is reduced from 2-3cm to 2-3mm, the distance is reduced by an order of magnitude, the power supply transmission loss is restricted and reduced.

By implementing power supply by using the PB module, power supply cost can be reduced, and power usage efficiency can be improved.

Compared with a horizontal power supply manner, the vertical power supply manner can reduce transmission loss and improve power utilization efficiency. A verification result shows that 400 million electricity charges can be saved in a life cycle for 100,000 servers.

Based on a same application concept as the foregoing vertical power supply system, an embodiment of the present disclosure provides a vertical power supply system, where the vertical power supply system may include a processor, a mainboard, and a vertical power supply circuit, and the vertical power supply circuit may include a PB carrier plate and a PB module.

The processor may be connected to a first surface of the mainboard through a plurality of first fixtures, and the PB carrier plate may be connected to a second surface of the mainboard through a plurality of second fixtures. The first surface may be a front surface and the second surface may be a back surface, or the first surface may be a back surface and the second surface may be a front surface.

For each second fixture, the second fixture corresponds to one first fixture, and, the second fixture is connected to a corresponding first fixture by a through hole in the mainboard.

The PB module is connected to the PB carrier plate through third fixtures, where the PB module is configured to convert an input power supply to a target power supply.

The target power supply supplies power to the processor through the third fixtures, the PB carrier plate, the second fixtures, the through holes in the mainboard and the first fixtures. It should be noted that the target power supply is used to supply power only to a processor (a single processor), and is not used to supply power to components other than the processor.

In an embodiment, the vertical power supply circuit may further include an input capacitor and an output capacitor corresponding to the PB module, the PB module is connected to the input capacitor, and the PB module is connected to the output capacitor.

The input power supply enters the PB module through the input capacitor; and after the PB module converts the input power supply into the target power supply, the target power enters the PB carrier plate through the output capacitor and the plurality of third fixtures.

In an embodiment, the number of PB modules is multiple, and each PB module corresponds to a plurality of input capacitors and a plurality of output capacitors, and a number of the output capacitors is more than a number of the input capacitors.

In an embodiment, the PB module is configured to convert the input power supply of a first voltage to the target power supply of a second voltage; where the first voltage may be a voltage supported by an external power supply, the second voltage may be a voltage supported by the processor, and the first voltage is greater than the second voltage, for example, the first voltage is 12V and the second voltage is 1V.

In an example, when a second fixture corresponds to a first fixture, a power supply type supported by the second fixture (for example, a pin definition corresponding to the second fixture) and a power supply type supported by the first fixture (for example, a pin definition corresponding to the first fixture) are same; the power supply type is a positive power supply electrode or a negative power supply electrode.

In an example, when the PB module is connected to the PB carrier plate through the plurality of third fixtures, the PB module and the plurality of third fixtures are placed on the front surface of the PB carrier plate; when the PB carrier plate is connected to the second surface of the mainboard through the plurality of second fixtures, the plurality of second fixtures are placed on the back surface of the PB carrier plate.

In an example, the first fixtures may include but are not limited to BGA solder balls; the second fixtures may include but are not limited to BGA solder balls; and the third fixtures may include but are not limited to BGA solder balls.

In an example, the processor may be a high-performance processor applied in artificial intelligence or big data; and the high-performance processor may include but is not limited to a high-performance CPU, a high-performance GPU, and a high-performance DPU.

In an example, the PB carrier plate may be a PB carrier plate optimized in a target optimization manner, and the target optimization manner may include but is not limited to at least one of the following: a copper plating optimization manner, a lamination optimization manner, a through hole optimization manner and a blind hole optimization manner, which is not limited.

In one example, the through holes on the motherboard are conductive through holes, and the through holes include copper plated through holes.

As can be seen from the above technical solution, a vertical power supply system is proposed so that the processor and the PB carrier plate are designed to be arranged back-to-back, that is, the processor is connected to the first surface of the mainboard through the first fixtures, the PB carrier plate is connected to the second surface of the mainboard through the second fixtures, thereby significantly reducing a distance between the processor and the PB carrier plate. Since the distance between the processor and the PB carrier plate is small, when the PB module is supplying power to the processor through the PB carrier plate, power supply transmission loss can be reduced, and heat dissipation of the power supply system is good.

For example, when a working current is large (e.g., 1000A), even though there is only a small change in the distance between the PB carrier plate and the processor, the power supply transmission loss can still be restricted and reduced. For example, when the distance is reduced from 2-3cm to 2-3mm, the distance is reduced by an order of magnitude, the power supply transmission loss is restricted and reduced.

By implementing power supply by using the PB module, power supply cost can be reduced, and power usage efficiency can be improved.

The foregoing is merely an embodiment of the present disclosure, and is not intended to limit the present disclosure. For those skilled in the art, the present disclosure may have various modifications and variations. Any modifications, equivalent substitutions, and improvements made within the spirit and principle of the present disclosure shall fall within the scope of the claims of the present disclosure.

## Claims

1. A vertical power supply system, comprising: a processor, a mainboard and a vertical power supply circuit, wherein the vertical power supply circuit comprises a power block (PB) carrier plate and a PB module;
the processor is connected to a first surface of the mainboard through first fixtures, the PB carrier plate is connected to a second surface of the mainboard through second fixtures; wherein the first surface is a front surface and the second surface is a back surface, or the first surface is a back surface and the second surface is a front surface;
for each of the second fixtures, the second fixture corresponds to one of the first fixtures, and the second fixture is connected to the corresponding first fixture by a through hole in the mainboard;
the PB module is connected to the PB carrier plate through third fixtures, wherein the PB module is configured to convert an input power supply to a target power supply; and
the target power supply is configured to supply power to the processor through the third fixtures, the PB carrier plate, the second fixtures, through holes in the mainboard and the first fixtures.

2. The vertical power supply system according to claim 1, wherein
the vertical power supply circuit further comprises an input capacitor and an output capacitor corresponding to the PB module, the PB module is connected to the input capacitor, and the PB module is connected to the output capacitor;
the input power supply enters the PB module through the input capacitor;
after the PB module converts the input power supply to the target power supply, the target power supply enters the PB carrier plate through the output capacitor and the third fixtures.

3. The vertical power supply system according to claim 2, wherein
the number of PB modules is multiple, and for each of the PB modules, the PB module corresponds to a plurality of input capacitors and a plurality of output capacitors, and a number of the output capacitors is more than a number of the input capacitors.

4. The vertical power supply system according to claim 1, wherein
the PB module is configured to convert the input power supply of a first voltage to the target power supply of a second voltage;
the first voltage is a voltage supported by an external power supply, the second voltage is a voltage supported by the processor, and the first voltage is greater than the second voltage.

5. The vertical power supply system according to claim 1, wherein
for one of the second fixtures and one of the first fixtures corresponding to each other, a power supply type supported by the second fixture is same as a power supply type supported by the first fixture; and the power supply type is a positive power supply electrode or a negative power supply electrode.

6. The vertical power supply system according to claim 1, wherein
when the PB module is connected to the PB carrier plate through the third fixtures, the PB module and the third fixtures are placed on a front surface of the PB carrier plate;
when the PB carrier plate is connected to the second surface of the mainboard through the second fixtures, the second fixtures are placed on a back surface of the PB carrier plate.

7. The vertical power supply system according to any one of claims 1-6, wherein
the first fixtures comprise ball grid array (BGA) solder balls;
the second fixtures comprise BGA solder balls;
the third fixtures comprise BGA solder balls.

8. The vertical power supply system according to any one of claims 1-6, wherein
the processor is a high-performance processor applied in artificial intelligence or big data;
the high-performance processor comprises a high-performance central processing unit (CPU), a high-performance graphics processing unit (GPU), and a high-performance data processing unit (DPU).

9. The vertical power supply system according to any one of claims 1-6, wherein
the PB carrier plate is a PB carrier plate optimized in a target optimization manner;
the target optimization manner comprises at least one of:
a copper plating optimization manner, a lamination optimization manner, a through hole optimization manner and a blind hole optimization manner.

10. The vertical power supply system according to any one of claims 1-6, wherein
the through holes in the mainboard are conductive through holes, and the through holes comprise copper-plated through holes.
